# EUROPEAN PATENT APPLICATION

(11) **EP 2 613 355 A2**
(43) Date of publication of application: **10.07.2013**
(21) Application number: 13150330.2
(22) Date of filing: 04.01.2013
(51) Int. Cl.: H01L 27/146, H01L 27/148

(54) **Cover for image sensor assembly with light absorbing layer**

(30) Priority: 05.01.2012 US 201213344486
(71) Applicant: Apple Inc., Cupertino, CA 95014 (US)
(72) Inventor: Gleason, Jeffrey N., Cupertino, CA California CA 95014 (US)
(74) Representative: Barton, Russell Glen

(57) **Abstract**

An image sensor assembly (100) includes an image sensor die (110) attached adjacent to a cavity (104) and a lower surface (109) in a preformed package having vertical surfaces (106) extending from the lower surface to an upper surface (108) of the package. The image sensor die may include a charge-coupled device or an active pixel sensor imager that provides the light receiving surface (112) for capturing the image. A cover (120) is placed over the upper surface of the package. The cover may be a glass cover or an infrared cut filter. A light absorbing layer (124) is applied to the cover in registry with the image sensor die such that the light absorbing layer prevents light from falling on the vertical surfaces of the preformed package without preventing the passage of light that falls on the light receiving surface of the image sensor die.

## Description

### BACKGROUND

### Field

Embodiments of the invention relate to the field of electronic image sensors; and more specifically, to electronic image sensors with means for attenuating spurious reflected light.

### Background

Electronic image sensors allow images to be captured in electronic form. Such sensors replace film in digital cameras and allow a camera function to be added to a variety of electronic devices such as cellular telephones, computers, and personal digital assistants. Image sensors are generally provided in the form of image sensor assemblies. The light that forms the image must fall on a light receiving surface of an image sensor die to capture the image. Therefore the image sensor die is provided in a package that is covered by a material that allows the image forming light to pass through to the light receiving surface. An image sensor assembly may include the image forming optics or may provide the image sensor to be used with external optics.

The image sensor die is often attached adjacent to a lower end of a cavity in the package. The cavity will often have vertical walls adjacent the image sensor die. Light can strike these vertical walls and be reflected onto the light receiving surface of the image sensor die and degrade the image. This reflected light may cause stray light to be cast toward the edge of the image.

It would be desirable to provide an image sensor assembly that reduces image degradation caused by light reflected from the vertical walls of the package cavity that houses the image sensor die.

### SUMMARY

An image sensor assembly includes an image sensor die attached adjacent to a cavity and a lower surface in a preformed package, such as a ceramic member, having substantially vertical surfaces extending from the lower surface to an upper surface of the package. The image sensor die may include a charge-coupled device or an active pixel sensor imager that provides the light receiving surface for capturing the image. A cover is placed over the upper surface of the package. The cover may be a glass cover or an infrared cut filter. A light absorbing layer is applied to the cover in registry with the image sensor die such that the light absorbing layer prevents light from falling on the substantially vertical surfaces of the preformed package without preventing the passage of light that falls on the light receiving surface of the image sensor die.

Other features and advantages of the present invention will be apparent from the accompanying drawings and from the detailed description that follows below.

### BRIEF DESCRIPTION OF THE DRAWINGS

The invention may best be understood by referring to the following description and accompanying drawings that are used to illustrate embodiments of the invention by way of example and not limitation. In the drawings, in which like reference numerals indicate similar elements:

FIG. 1 is an exploded view of an image sensor assembly that embodies the invention.

FIG. 2 is an assembled view of the image sensor assembly of Figure 1.

FIG. 3 is a section view of the image sensor assembly along line 2--2 of Figure 2.

FIG. 4 is a section view of another image sensor assembly that embodies the invention.

FIG. 5 is a section view of an image sensor assembly that embodies the invention assembled with imaging optics.

FIG. 6 is a section view of yet another image sensor assembly that embodies the invention.

### DETAILED DESCRIPTION

In the following description, numerous specific details are set forth. However, it is understood that embodiments of the invention may be practiced without these specific details. In other instances, well-known circuits, structures and techniques have not been shown in detail in order not to obscure the understanding of this description.

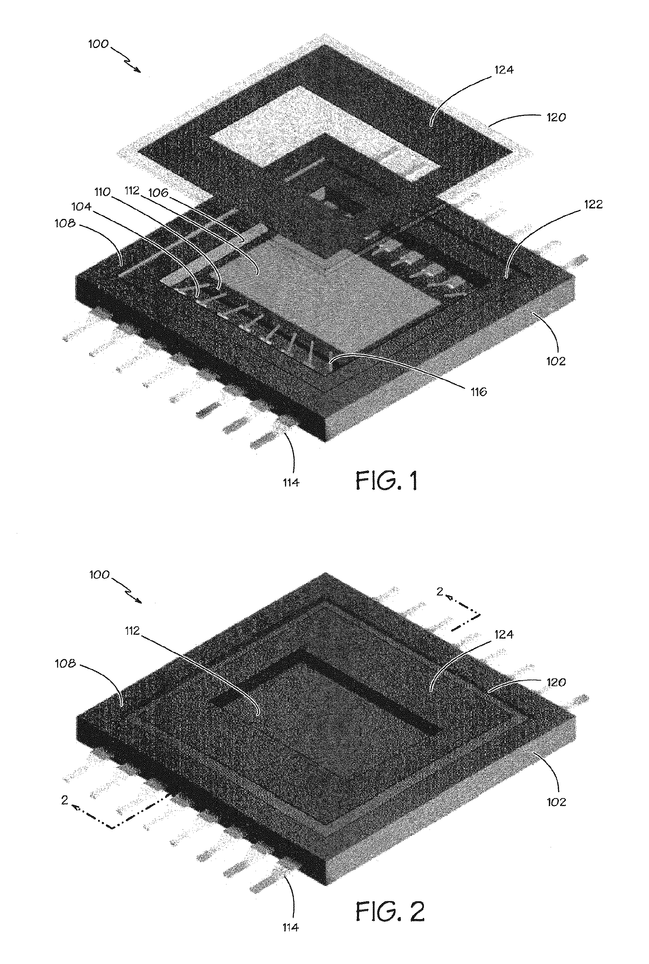

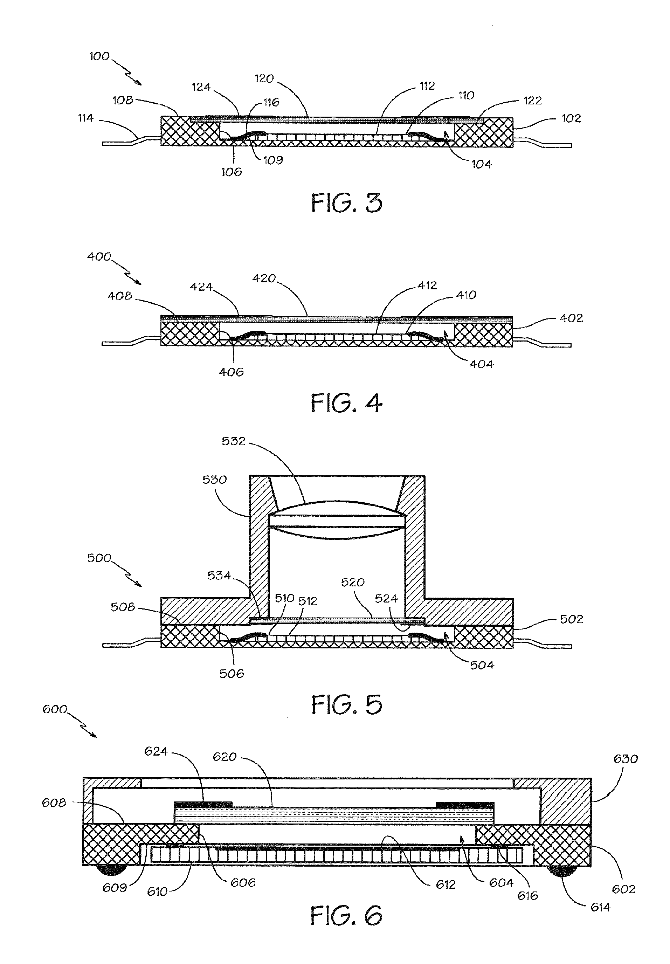

FIG. 1 shows an exploded view of an image sensor assembly 100 that embodies the invention. FIG. 2 shows an assembled view of the image sensor assembly of Figure 1. FIG. 3 is a section view of the image sensor assembly along line 2--2 of Figure 2.

The assembly 100 includes a package 102, which may be a preformed ceramic member, that includes a cavity 104 having substantially vertical surfaces 106 extending from a lower surface 109 to an upper surface 108 of the package. An image sensor die 110 is attached to the package 102 adjacent the cavity 104 and the lower surface of the package. The image sensor die 110 has a light receiving surface 112 for capturing an image. The image sensor die 110 may include a charge-coupled device or an active pixel sensor imager that provides the light receiving surface 112 for capturing the image. The package 102 will typically provide external electrical connections 114, such as pins, a ball grid array, or surface mount connections, that are electrically coupled 116 to the image sensor die 110.

A cover 120 is placed over the upper surface 108 of the package 102. Placed over the upper surface of the package should be understood to mean placed adjacent the surface of the package that is closest to the image forming optics. The cover 120 may be placed in a recess 122 in the top of the package 102 such that the top surface of the cover is flush with or somewhat recessed from the uppermost surface of the package. The cover 120 is generally spaced apart from the image sensor die 110.

The cover 120 may be a glass cover that allows image forming light to pass through to the image sensor, an infrared cut filter that prevents infrared radiation from passing through to the image sensor, or other material that seals the cavity 104 of the package 102 while allowing image forming light to fall on the light receiving surface 112 of the image sensor die 110. A light absorbing layer 124 is applied to the cover in registry with the image sensor die 110. The light absorbing layer 124 prevents light from falling on the substantially vertical surfaces 106 of the cavity 104 of the package 102 without preventing the passage of light that falls on the light receiving surface 112 of the image sensor die 110. By preventing light from falling on the substantially vertical surfaces 106, the light absorbing layer 124 attenuates light that could reflect onto the light receiving surface 112 of the image sensor die 110 and degrade the image formed.

It is important that the light absorbing layer 124 be accurately aligned with the light receiving surface 112 of the image sensor die 110 so that the captured image is not affected by the light absorbing layer. It is desirable that the light absorbing layer 124 be closely fit to the light receiving surface 112 to that the image sensor die 110 can be close to the vertical walls 106 to keep the package 102 compact. Since the light receiving surface 112 is normally accurately located on the. image sensor die 110, it is generally sufficient to align the light absorbing layer 124 with respect to the image sensor die 110. Preferably the light absorbing layer 124 is applied to the cover in registry with the image sensor die 110 within one hundred microns and more preferably within forty microns. Registry of the light absorbing layer with the image sensor die within a given distance means that distance between the optical axes of the two components is no greater than the given distance. It also important that the light absorbing layer and the image sensor die be aligned closely with regard to rotational displacements. To achieve the necessary accuracy of alignment, the light absorbing layer may be a photo resist material with the boundaries established by optical techniques, precision ink jet printing, or other techniques that allow the light absorbing layer to be applied to the cover with highly accurate positioning. While the light absorbing layer 124 is shown not extending to the edges of the cover 120 to allow the light absorbing layer to be seen more clearly, it is preferable that the light absorbing layer extend to the edges of the cover to block all light except that which passes through the central opening in the light absorbing layer.

FIG. 4 shows a section view of another image sensor assembly 400 that embodies the invention. The image sensor assembly 400 includes an image sensor die 410 attached to a floor at a lower end of a cavity 404 in a preformed package 402 having substantially vertical surfaces 406 extending from the floor to an upper surface 408 of the package. A cover 420 is placed over the upper surface 408 of the package 402. In this embodiment the bottom surface of the cover is attached to the upper surface of the package without use of a recess to receive the cover. A light absorbing layer 424 is applied to the cover 420 in registry with the image sensor die 410 such that the light absorbing layer prevents light from falling on the substantially vertical surfaces 406 of the preformed package 402 without preventing the passage of light that falls on the light receiving surface 412 of the image sensor die. In this embodiment the light absorbing layer 424 extends to the edges of the cover 420.

FIG. 5 shows a section view of an image sensor assembly that embodies the invention assembled with imaging optics. The image sensor assembly 500 includes an image sensor die 510 attached to a floor at a lower end of a cavity 504 in a preformed package 502 having substantially vertical surfaces 506 extending from the floor to an upper surface 508 of the package. An imaging optics assembly 530 that includes one or more lenses 532 is attached to the upper surface 508 of the image sensor package 502. A cover 520 is placed in a recess in the imaging optics assembly 530 attached to the upper surface of the image sensor package 502 as part of the imaging optics assembly. A light absorbing layer 524 is applied to the cover 520. It will be observed that in this embodiment the light absorbing layer is on the surface of the cover closest to the image sensor die 510. The imaging optics assembly 530 is assembled to the image sensor package 502 in registry with the image sensor die 510. Thus the light absorbing layer 524 is also in registry with the image sensor die 510 such that the light absorbing layer prevents light from falling on the substantially vertical surfaces 506 of the preformed package 502 without preventing the passage of light that falls on the light receiving surface 512 of the image sensor die.

FIG. 6 shows a section view of yet another image sensor assembly 600 that embodies the invention. This image sensor assembly 600 uses flip chip construction, also known as Controlled Collapse Chip Connection (C4), to attach an image sensor die 610 to a preformed package 602. The preformed package 602 defines a cavity 604 having substantially vertical surfaces 606 extending from a lower surface 609 to an upper surface 608 of the package. The image sensor die 610 is coupled to the preformed package 602 both mechanically and electrically by conductive bonds 616, such as solder bumps on the image sensor die that are re-melted to produce an electrical connection to the preformed package. The preformed package 602 provides an electrical connection from the conductive bonds 616 to external electrical connections 614, such as a ball grid array, pins, or surface mount connections.

The flip chip construction allows the image sensor assembly 600 to be more compact than the wire bond construction previously illustrated. However, is also results in the substantially vertical surfaces 606 of the cavity 604 being closer to the light receiving surface 612 of the image sensor die 610. A cover 620 is placed over the upper surface 608 of the package 602. A light absorbing layer 624 is applied to the cover 620 in registry with the image sensor die 610 such that the light absorbing layer prevents light from falling on the substantially vertical surfaces 606 of the preformed package 602 without preventing the passage of light that falls on the light receiving surface 612 of the image sensor die. An upper housing 630 may also be placed over the upper surface 608 of the package 602 to provide mechanical protection for the cover 620.

While certain exemplary embodiments have been described and shown in the accompanying drawings, it is to be understood that such embodiments are merely illustrative of and not restrictive on the broad invention, and that this invention is not limited to the specific constructions and arrangements shown and described, since various other modifications may occur to those of ordinary skill in the art. The description is thus to be regarded as illustrative instead of limiting.

Further aspects of the invention :
1. An image sensor assembly comprising:
   a preformed package that includes a cavity having substantially vertical surfaces extending from a lower surface to an upper surface of the package;
   an image sensor die attached adjacent to the cavity and the lower surface of the preformed package, the image sensor die having a light receiving surface for capturing an image;
   a cover placed over the upper surface of the package; and
   a light absorbing layer applied to the cover in registry with the image sensor die such that the light absorbing layer prevents light from falling on the substantially vertical surfaces of the preformed package without preventing the passage of light that falls on the light receiving surface of the image sensor die.
2. The image sensor assembly of number 1 further comprising electrical connections coupled between the image sensor die and the package.
3. The image sensor assembly of number 1 wherein the cover is a glass cover that allows image forming light to pass through to the image sensor.
4. The image sensor assembly of number 1 wherein the cover is an infrared cut filter that prevents infrared radiation from passing through to the image sensor.
5. The image sensor assembly of number 1 wherein the light absorbing layer is applied to the cover in registry with the image sensor die within one hundred microns.
6. The image sensor assembly of number 1 wherein the light absorbing layer is applied to the cover in registry with the image sensor die within forty microns.
7. The image sensor assembly of number 1 wherein the image sensor die includes a charge-coupled device that provides the light receiving surface for capturing the image.
8. The image sensor assembly of number 1 wherein the image sensor die includes an active pixel sensor imager that provides the light receiving surface for capturing the image.
9. A method of packaging an image sensor comprising:
   attaching an image sensor die to a preformed package such that the image sensor die is located adjacent a cavity in the package with substantially vertical surfaces adjacent to a light receiving surface of the image sensor die;
   placing a cover over an upper surface of the package; and
   applying a light absorbing layer on the cover glass in registry with the image sensor die such that the light absorbing layer prevents light from falling on the substantially vertical surfaces of the preformed package without preventing the passage of light that falls on the light receiving surface of the image sensor die for capturing an image.
10. The method of number 9 further comprising providing electrical connections between the image sensor die and the package.
11. The method of number 9 wherein the cover is a glass cover that allows image forming light to pass through to the image sensor.
12. The method of number 9 wherein the cover is an infrared cut filter that prevents infrared radiation from passing through to the image sensor.
13. The method of number 9 wherein the light absorbing layer is applied to the cover in registry with the image sensor die within one hundred microns.
14. The method of number 9 wherein the light absorbing layer is applied to the cover in registry with the image sensor die within forty microns.
15. The method of number 9 wherein the image sensor die includes a charge-coupled device that provides the light receiving surface for capturing the image.
16. The method of number 9 wherein the image sensor die includes an active pixel sensor imager that provides the light receiving surface for capturing the image.
17. An image sensor assembly comprising:
   means for packaging an image sensor die such that the image sensor die is located adjacent to a cavity with substantially vertical surfaces adjacent to a light receiving surface of the image sensor die;
   means for covering an upper surface of the means for packaging that allows image forming light to pass through to the image sensor die; and
   means for absorbing light that is applied to the means for covering to prevent light from falling on the substantially vertical surfaces of the preformed ceramic member without preventing the passage of the image forming light that falls on the light receiving surface of the image sensor die for capturing an image.
18. The image sensor assembly of number 17 further comprising means for electrically connecting the image sensor die and the means for packaging.
19. The image sensor assembly of number 17 wherein the means for covering is a glass cover that allows image forming light to pass through to the image sensor.
20. The image sensor assembly of number 17 wherein the means for covering is an infrared cut filter that prevents infrared radiation from passing through to the image sensor.
21. The image sensor assembly of number 17 wherein the means for absorbing light is applied to the means for covering in registry with the image sensor die within one hundred microns.
22. The image sensor assembly of number 17 wherein the means for absorbing light is applied to the means for covering in registry with the image sensor die within forty microns.
23. The image sensor assembly of number 17 wherein the image sensor die includes a charge-coupled device that provides the light receiving surface for capturing the image.
24. The image sensor assembly of number 17 wherein the image sensor die includes an active pixel sensor imager that provides the light receiving surface for capturing the image.

## Claims

1. An image sensor assembly comprising:
a preformed package that includes a cavity having substantially vertical surfaces extending from a lower surface to an upper surface of the package;
an image sensor die attached adjacent to the cavity and the lower surface of the preformed package, the image sensor die having a light receiving surface for capturing an image;
a cover placed over the upper surface of the package; and
a light absorbing layer applied to the cover in registry with the image sensor die such that the light absorbing layer prevents light from falling on the substantially vertical surfaces of the preformed package without preventing the passage of light that falls on the light receiving surface of the image sensor die.

2. The image sensor assembly of claim 1 further comprising electrical connections coupled between the image sensor die and the package.

3. The image sensor assembly of any preceding claim wherein the cover is a glass cover that allows image forming light to pass through to the image sensor.

4. The image sensor assembly of claim 1 or 2 wherein the cover is an infrared cut filter that prevents infrared radiation from passing through to the image sensor.

5. The image sensor assembly of any preceding claim wherein the light absorbing layer is applied to the cover in registry with the image sensor die within one hundred microns.

6. The image sensor assembly of any preceding claim wherein the image sensor die includes a charge-coupled device that provides the light receiving surface for capturing the image.

7. The image sensor assembly of any of claims 1 to 5 wherein the image sensor die includes an active pixel sensor imager that provides the light receiving surface for capturing the image.

8. A method of packaging an image sensor comprising:
attaching an image sensor die to a preformed package such that the image sensor die is located adjacent a cavity in the package with substantially vertical surfaces adjacent to a light receiving surface of the image sensor die;
placing a cover over an upper surface of the package; and
applying a light absorbing layer on the cover glass in registry with the image sensor die such that the light absorbing layer prevents light from falling on the substantially vertical surfaces of the preformed package without preventing the passage of light that falls on the light receiving surface of the image sensor die for capturing an image.

9. The method of claim 8 further comprising providing electrical connections between the image sensor die and the package.

10. The method of claim 8 or 9 wherein the cover is a glass cover that allows image forming light to pass through to the image sensor.

11. The method of claim 8 or 9 wherein the cover is an infrared cut filter that prevents infrared radiation from passing through to the image sensor.

12. The method of any of claims 8 to 11 wherein the light absorbing layer is applied to the cover in registry with the image sensor die within one hundred microns.

13. The method of any of claims 8 to 11 wherein the light absorbing layer is applied to the cover in registry with the image sensor die within forty microns

14. The method of any of claims 8 to 13 wherein the image sensor die includes a charge-coupled device that provides the light receiving surface for capturing the image.

15. The method of any of claims 8 to 13 wherein the image sensor die includes an active pixel sensor imager that provides the light receiving surface for capturing the image.
